# EUROPEAN PATENT SPECIFICATION

(11) **EP 2 407 016 B1**
(45) Date of publication and mention of the grant of the patent: **24.10.2012**
(21) Application number: 10711068.6
(22) Date of filing: 15.03.2010
(51) Int. Cl.: H05K 7/20, G06F 1/20

(54) **EQUIPMENT ENCLOSURE**
GERÄTEGEHÄUSE
ENCEINTE POUR ÉQUIPEMENTS

(30) Priority: 13.03.2009 GB 0904358
(43) Date of publication of application: 18.01.2012
(73) Proprietor: 4Energy Limited, Debdale Industrial Estate Keyworth Nottinghamshire NG12 5HN (GB)
(72) Inventor: REDSHAW, Stuart, Peter, Nottingham NG11 0EB (GB)
(74) Representative: Pearce, David Henry
(86) International application number: PCT/GB2010/000467
(87) International publication number: WO 2010/103293

(56) References cited:
- US-A- 4 495 545
- US-A- 5 934 368
- US-A1- 2008 185 446
- US-A1- 2009 009 958

## Description

The invention relates to ventilation and temperature control of enclosures for electronic equipment, and in particular to apparatus and methods for controlling air flow within such enclosures.

Enclosures for electrical and electronic equipment typically require ventilation to allow the equipment therein to expel waste heat to an external environment to avoid overheating. In applications where electrical equipment is to be used in remote locations, for example in mobile radio telecommunications base stations, equipment is typically left unattended for extended periods. To ensure that the temperature of the equipment is kept within a preferred temperature range, additional cooling and ventilation apparatus is normally required. Depending on complexity, this cooling equipment consumes energy, which is both expensive and sometimes in limited supply, and also require maintenance to avoid the costly implications of failure.

In a typical radio telecommunications base station, electrical equipment operating the radio frequency (RF) signals is kept inside a ventilated cabinet, which itself is kept within a sealed equipment room, or enclosure, providing protection from external conditions. Often, fans within the cabinet circulate air through the electrical equipment to provide cooling, and the air temperature within the equipment room is maintained through the use of an air conditioning unit, which expels waste heat generated by the electrical equipment to the external environment. The air conditioning unit must work to maintain the temperature of the interior of the room within a desired range, to ensure that the equipment within the room operates reliably. This uses a significant amount of power in addition to that required to operate the electrical equipment itself.

A backup power supply in the form of a cabinet of batteries (typically lead-acid batteries) is often necessary in case of a break in electrical power to the equipment room. Such batteries also need to be kept within a desired temperature range, this range being generally.more stringent than for other electrical equipment. In a typical equipment room therefore, the air conditioning unit often operates to maintain an internal temperature range dependent upon the requirements of the batteries rather than of the electrical equipment, which is generally able to operate at higher temperatures without any problems. This results in the air conditioning unit having to work harder than is strictly necessary to maintain proper operation of all equipment in the room.

In temperate climates such as in the UK, the ratio of cooling power to equipment power is approximately 1 to 4. So if 4kW is used by the electronics 1 kW will typically be required by the cooling system. In hotter climates this ratio may reduce to 1 to 3 or even 1 to 2. Clearly in summer the actual day to day consumption may be much higher, but these loads may be offset to some extent in winter.

Therefore an air conditioning unit in a typical equipment room may operate at up to 1kW, compared with the operating power of the other electrical equipment of up to 4kW. This requirement can be reduced by providing for separate cooling of the battery backup, allowing the internal temperature of the room to rise to a higher maximum temperature. For example, ensuring the whole room is kept at a temperature of below 20°C to accommodate battery requirements will tend to use substantially more power than allowing the maximum temperature to rise to 35°C, at which temperature most electrical equipment will still operate without problems. This does not, however, remove the need for air conditioning of such rooms, as some cooling will still be required to prevent the maximum temperature from being exceeded under certain conditions.

A further problem with using air conditioning units in equipment rooms, particularly when such rooms are in remote locations, is that of servicing and repairing. If an air conditioning unit breaks down in use, the electrical equipment is put at risk of failure, and a specialist engineer (usually different from an electrical equipment engineer) must be called out to fix the unit. This can substantially add to the cost of maintaining such equipment rooms. It might also not be known, for example when an equipment room provides an automatic failure indication, what has caused the failure. An electrical equipment engineer could therefore be called out, when what is required is an air conditioning engineer. Multiple visits can then further add to the costs of maintaining operation.

One common alternative approach is, instead of keeping the equipment room sealed and refrigerated, to maintain a high air flow through the room by means of a large fan arranged to force air through air vents provided in the room. To maintain a desired temperature range, however, and to minimise a temperature differential between the interior and exterior of the room, a large airflow is required, requiring a large and powerful fan. Furthermore, air being drawn through the room will tend to draw dirt and dust from the external environment into the room, so the airflow will need to be filtered. Adding filters will inevitably result in a requirement for maintenance visits to check and replace the filters so that a sufficiently high airflow can be maintained. Simply replacing air conditioning with fan cooling does not therefore fully address the problem of requiring separate maintenance visits, nor does it necessarily substantially reduce the power requirements of the room, since large fans require large power inputs. High airflows also tend to draw in more dirt and dust, causing filters to eventually clog.

An improved alternative to the use of air conditioning or large fans is to direct heat generated by the electrical equipment within the room to the external environment, for example by using exhaust ducts extending from the equipment cabinets to the outside wall of the room. Air drawn into the equipment cabinet by an internal fan can then be exhausted to the external environment more directly, reducing heating of the room by heat generated by the electrical equipment. This results in a much reduced need for airflow through the room. Smaller fans, with much reduced power requirements, can then be used to extract air from the room, replacing the air through intake vents in the room.

The above solution does not, however, remove the need for maintenance visits, because air filters will still be required in the intake vents in the room, and these will occasionally need to be replaced. One way of overcoming this problem is to provide an air filter of the type disclosed in GB2456541.

It is therefore possible to operate electronic equipment enclosures, such as the type used for mobile telephone base stations, without air conditioning, provided the external temperature does not exceed the maximum allowable internal temperature of the enclosure by an amount equal to the minimum temperature differential the enclosure is capable of maintaining. For example, if the maximum temperature within the enclosure is to be no higher than 35°C, and the minimum temperature differential is 5°C, the maximum allowable external temperature in which the enclosure can operate is 30°C.

If, however, the enclosure is to be used in environments where external temperatures are likely to exceed the maximum allowable temperature, additional active cooling will still be required if the maximum allowable temperature within the enclosure is not to be exceeded.

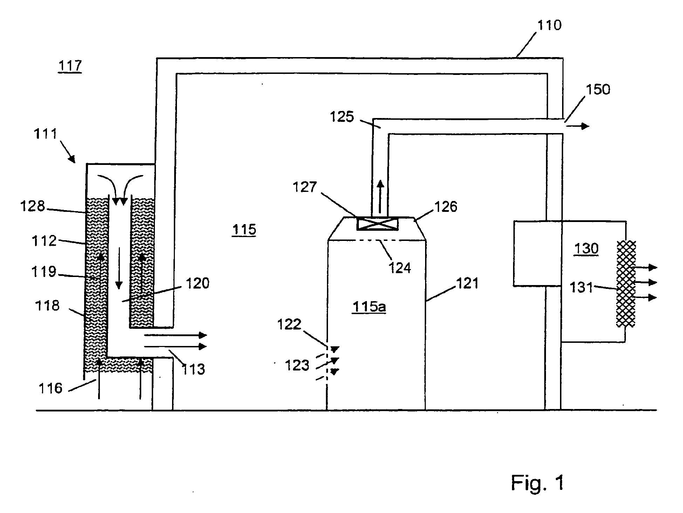

Illustrated in figure 1 is a schematic cross-sectional view of an exemplary equipment enclosure 110. An air filter 111, for example of the type disclosed in GB2456541, is provided in the form of a wall-mounted box 112, with an air outlet 113 extending into an internal volume 115 of the room 110. A wider air inlet 116 is configured to allow air to be drawn from the external environment 117 through a duct comprising in series an inlet passageway 118 and an outlet passageway 120 extending between the inlet 116 and outlet 113 of the air filter 111, with the direction of airflow indicated by arrows 119.

The air filter 111 is mounted on the equipment enclosure 110 such that the inlet passageway 118 is oriented to allow airflow 119 vertically upwards through the inlet passageway 118, and then vertically downwards through an air outlet passageway 120 towards the air outlet 113.

Shown within the internal volume 115 of the room 110 is an electronic equipment cabinet 121, which defines a further internal volume 115a within which various electronic equipment (not shown) can be arranged. An air inlet vent 122 is provided to allow air from the internal volume 115 to enter the cabinet 121, the airflow indicated by arrows 123. A further air vent 124 is provided to allow air to exit the equipment cabinet 121 and into an air exhaust duct 125 via a hood 126 on top of the cabinet 121. An exhaust fan 127 forces air out of the duct 125 and out of the enclosure 110 to the external environment 117. The fan 127 thereby provides a driving force, in the form of a partial vacuum created within the internal volume 115, to draw air from the external environment 117 into the internal volume 115 through the air filter 111. Provided the room 110 is otherwise sufficiently sealed, the fan 127 alone can, under normal circumstances, provide all the air flow through the room 110 required to provide cooling of the internal volume 115 and of equipment within the enclosure 121, provided the external temperature does not rise above the maximum allowable temperature. Because air from the cabinet 121 is prevented from recirculating within the main internal volume 115 of the enclosure 110, the requirement for cooling within the enclosure 110 is reduced, as compared with conventional solutions involving air conditioning of the whole of the internal volume 115. The exhaust fan 127 can alternatively be situated at the air inlet to the room 110, i.e. immediately adjacent to the outlet 113 of the air filter 111, making the room volume 115 positive pressure relative to the external environment 117.

To prevent the internal temperature of the equipment enclosure 110 from rising above a preset maximum, an air conditioning unit 130 may be incorporated, and configured to activate once the internal measured temperature rises above (or approaches) this present maximum. The air conditioning unit 130 works to cool and recirculate air within the enclosure, exhausting waste heat to the external environment via a heat exchanger 131 on the outside of the enclosure 110. The use of such an air conditioning system in conjunction with the other components of the enclosure 110 shown in figure 1, however, results in the possibility of an excessive amount of energy being used to cool the enclosure 110. With the air conditioner 130 in operation, cool air is recirculated within the whole internal volume 115 of the enclosure 110. This air is also drawn into the equipment cabinet 121, and then exhausted out through duct 125 and out to the external environment via the exhaust fan 127. A problem with this approach is that cool air, i.e. having a temperature lower than that of the external environment, can be exhausted back to the external environment rather than being recirculated within the enclosure to provide further cooling. This results in wasted energy being consumed in operating the air conditioner, and extends the time over which the unit 130 needs to be in operation. This can be exacerbated as fans in equipment enclosures tend to be oversized and crudely controlled. Another problem with forced air cooling can be that of overcooling. When the outside temperature falls low, continuous forced air cooling can result in overcooling of equipment sensitive to low temperatures. Consequently, when operating in cold weather conditions, equipment within the enclosure may fail due to a constant supply of cold air being drawn through the enclosure, which could cause the temperature of equipment within the enclosure falling below a minimum operating temperature.

One possible solution to address the above problem is to use an air flow diverter. An air flow diverter, positioned for example in the exhaust conduit, may be used to actively divert air from flowing through the exhaust and out into the external environment when it would be a more efficient use of energy to instead recirculate air within the enclosure. Active control of air flow in this way can reduce the need for energy-intensive air conditioning.

The use of active control of air flow does, however, result in further components, including moving parts and electrical controls, which may at some point either break down or require maintenance to ensure their continued operation.

It is consequently an object of the invention to reduce energy wastage in equipment enclosures, while maintaining thermally sensitive equipment within safe operating temperatures and while minimising the use of additional moving parts and electrical controls.

US 4,495,545 discloses an enclosure for electrical equipment that is arranged in sections, in which air is constantly circulated through the sections in a closed loop, a pivotal baffle arranged having two positions: one in which access to an inlet and outlet of the enclosure is shut off and another in which circulation is shut off between sections at one end and access is opened between the inlet and outlet to allow air circulation through the sections.

According to a first aspect of the invention there is provided a temperature-controllable equipment enclosure comprising:
an air inlet having an inlet fan arranged to supply air into the enclosure from an external environment through the air inlet to provide a positive air pressure within the enclosure when enabled;
an air outlet;
a conduit extending between the outlet and an equipment cabinet within the internal volume of the enclosure; and
an exhaust fan arranged to drive air through the cabinet and conduit towards the outlet;
wherein the conduit comprises a passive air bypass connecting the internal volume of the enclosure with the interior of the conduit, such that air driven by the exhaust fan is recirculated within the internal volume of the enclosure when the inlet fan is disabled and is exhausted from the enclosure through the air outlet when the air inlet fan is enabled.

The air bypass is passive in the sense that no additional control or actuation is required to enable the enclosure to switch between a first mode where air passes through the enclosure and a second mode where air is recirculated within the enclosure.

An advantage of the above arrangement is that the enclosure can be operated in the first mode where air flows through the enclosure to provide cooling and the second mode where air is recirculated to provide heating, a transition between the two modes being enabled merely by enabling or disabling the inlet fan. No further moving parts are required, thereby simplifying construction and reducing the possibility of breakdown.

The invention allows the need for additional heaters for operation of equipment within the enclosure in cold weather conditions to be either reduced or eliminated, because waste heat from the equipment itself can be used to provide heating in such conditions. This consequently allows the geographic operational range of such cooling systems, known as directed air (or DA) systems, to be extended into regions having colder climates.

The use of the passive air bypass further improves the efficiency of DA systems in hot climates, where refrigeration is required, by the ability to choose which mode the enclosure is operated in by operation of the inlet fan.

Due to the reduction of moving parts, the reliability of the system is improved compared to conventional directed air flow systems, in which flow valves and actuators are typically used to control air flow in different operational modes.

The air bypass may be in the form of one or more holes in the conduit itself or in a manifold connecting the cabinet with the conduit.

The air bypass may be configured to control the amount of air that is recirculated back into the internal volume of the enclosure, in particular through the cross-sectional area available for air to flow through the bypass. A smaller cross-section will tend to reduce the amount of air being recirculated when the inlet fan is operational, but will tend to restrict recirculation when the inlet fan is disabled. A larger cross-section, on the other hand, will tend to increase recirculation when the inlet fan is enabled, thereby reducing the cooling effect of air flow through the enclosure. An optimum size of air bypass is therefore preferred, being dependent on factors such as the air flow rates of each of the inlet and exhaust fans and the specific dimensions of the enclosure, cabinet and conduit.

The equipment enclosure preferably comprises a temperature controller configured to disable the inlet fan when an air temperature within the enclosure falls below a preset level. By disabling the inlet fan, a positive pressure causing air to pass through and out of the enclosure is removed, and air is instead mainly recirculated within the enclosure by passing from within the conduit and back into the internal volume of the enclosure via the air bypass. Heat generated by equipment within the cabinet is then used to warm the interior of the enclosure, thereby preventing the temperature within the enclosure from falling below a minimum operating temperature without requiring additional heating.

The equipment enclosure optionally comprises a valve biased towards a closed position and configured to restrict air flow through the conduit towards the air outlet when the inlet fan is disabled. The biased valve reduces air leakage through the outlet when the enclosure is in the recirculation mode, preventing air from being drawn into the enclosure through the disabled inlet fan or through the air outlet. Such a valve may be in the form of a lightly sprung hinged flap disposed in the conduit, the flap being configured to be opened by the action of a positive pressure within the enclosure. The valve is preferably a one-way valve, only allowing air to pass out through the air outlet, or exhaust.

The enclosure preferably comprises an air conditioning unit configured to operate to cool air within the enclosure if an air temperature within the enclosure exceeds a maximum preset temperature. The air conditioning unit allows for the enclosure to be used in external environments when forced air cooling alone would be insufficient to maintain the internal volume of the enclosure within a preferred temperature range.

The air conditioning unit is preferably configured to cease operation if the air temperature within the enclosure is greater than a measured external temperature by a preset temperature differential and if the measured external temperature is lower than the maximum external temperature by more than the preset temperature differential. Controlling the air conditioning unit in response to the external air temperature, rather than the internal air temperature, allows the air conditioning unit to be turned off when forced air cooling would be sufficient to maintain the internal temperature within the preferred temperature range.

According to a second aspect of the invention there is provided a method of operating a temperature-controllable equipment enclosure according to the first aspect, the method comprising:
operating the inlet fan to drive air into the enclosure;
operating the exhaust fan to drive air through the conduit towards the air outlet; and
ceasing operation of the inlet fan and continuing operation of the exhaust fan when a measured air temperature within the internal volume of the enclosure falls below a preset minimum temperature, to cause air to recirculate within the internal volume via the air bypass.

The invention will now be described by way of example and with reference to the accompanying drawings, in which:
figure 1 illustrates in schematic cross-section an exemplary equipment enclosure having air cooling;
figure 2 illustrates in schematic cross-section an exemplary equipment enclosure comprising an air bypass, the enclosure operating in a through-flow configuration;
figure 3 illustrates in schematic cross-section an exemplary equipment enclosure comprising an air bypass, the enclosure operating in a recirculating configuration; and
figure 4 is a flow diagram illustrating an exemplary method of operating the equipment enclosure.

The equipment room 110 illustrated in figure 1 has already been described as part of the background section above.

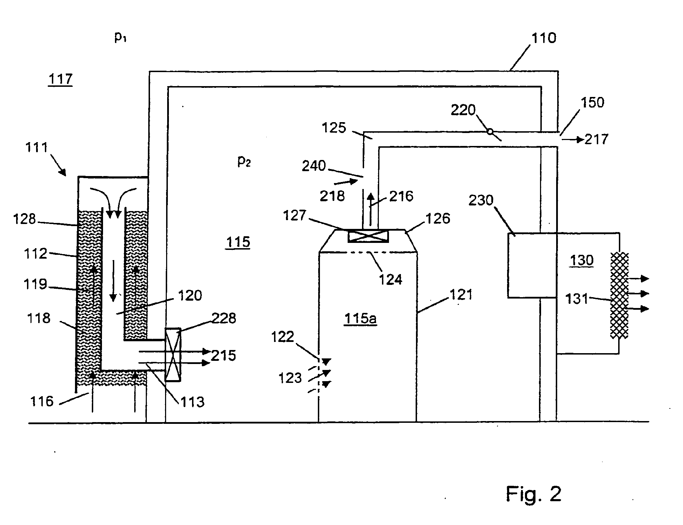

Figure 2 illustrates an exemplary equipment enclosure 110 as in figure 1, but with certain modifications made in accordance with an aspect of the invention, including incorporation of an air inlet fan 228 and an air bypass 240 provided in the conduit 125. The air bypass 240 is shown in the form of a hole in the wall of the conduit 125. The air bypass 240 may alternatively be provided in the hood or manifold 126 connecting the cabinet 121 to the conduit 125. In the illustrated configuration, air flow through the enclosure 110 is achieved by means of the inlet fan 228 at the inlet 113 to the enclosure 110, which is operational to create a positive pressure within the internal volume 115, in combination with the exhaust fan 127 forcing air through the conduit 125 towards the air exhaust 150. The internal pressure p₂ is consequently higher than the external (ambient atmospheric) pressure p₁. This pressure differential (p₂-p₁) creates a driving force for air to pass into the conduit through the air bypass 240 and out of the enclosure through the exhaust 150. Air does not consequently recirculate back into the internal volume 115 of the enclosure 110 when both fans 228, 127 are operational, provided the enclosure 110 is adequately sealed to prevent air from escaping out of the enclosure anywhere other than the air exhaust 150.

In the configuration shown in figure 2, therefore, air passes in the direction indicated by arrows 215, 123, 216, 217 from the air inlet 113, through the cabinet 121, through the exhaust fan 127 and out of the enclosure through the conduit 125 and air exhaust 150 towards the external environment. A proportion of the air driven by the inlet fan 228 passes into the conduit 125 through the air bypass 240, as indicated by arrow 218, the amount of which is determined by the cross-section of the bypass 240. A larger bypass 240 will result in a greater proportion of input air flowing through the bypass 240 compared with that flowing through the cabinet 121.

Also shown in figure 2 is an optional valve 220 provided as part of the conduit 125. The valve 220 is shown in figure 2 in an open configuration caused by the pressure differential between air within the enclosure 110 and air external to the enclosure 110.

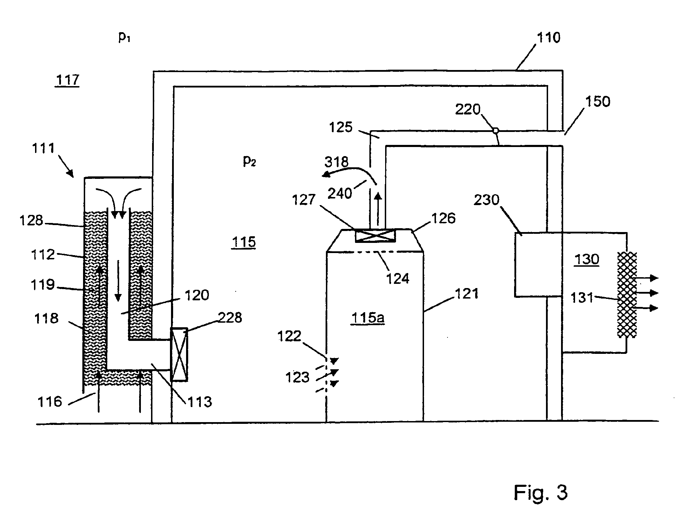

Figure 3 illustrates the enclosure 110 in a second mode, when the air inlet fan 228 is disabled. This causes the internal pressure p₂ to fall, and the driving force for air to exhaust out of the enclosure through the air exhaust 150 to be reduced. As a result, air driven by the exhaust fan 127 passes mainly through the air bypass 240 and back into the internal volume 115 of the enclosure 110, indicated by arrow 318, thereby recirculating heat generated by the equipment within the cabinet 121. This configuration has the advantage that additional heating may not be required to prevent the equipment within the enclosure from falling below a minimum operating temperature when external temperatures are low. A further advantage, outlined in more detail below, is that of reducing the energy requirements when air conditioning becomes necessary due to external temperatures becoming high.

The optional valve 220, shown in figure 3 in a closed configuration, further reduces the flow of air out of the enclosure 110 when the air inlet fan 228 is disabled. The valve 220 is configured to pass air out of the enclosure when a minimum differential between the internal pressure of the enclosure and the external environment is exceeded. This may be achieved by means of a lightly biased spring-loaded flap, the flap being biased by a spring towards being closed when this pressure differential is low. The valve 220 also serve as a one-way valve to prevent air from being drawn into the enclosure through the air exhaust 150. Other means for increasing a back-pressure in the enclosure 110 may alternatively be used, such as an actuated valve that is configured to close the air exhaust 150 when the air inlet fan 228 is disabled. In general terms, such means for increasing the back-pressure within the enclosure 110 allow further control of an air bypass ratio, being the amount of air leaking out of the enclosure 110 when the air inlet fan 228 is disabled compared with the air flowing into and out of the enclosure 110 when the air inlet fan 228 is enabled. Further components that may affect this ratio include optional features such as an exhaust grill or cover at the air exhaust 150, any other flow restricting elements within the conduit 125, as well as the internal dimensions of the conduit 125 itself.

An air conditioning unit 130, shown in figures 2 and 3, is installed on a side wall of the equipment enclosure 110. When operational, the air conditioning unit 130 recirculates and cools air within the internal volume 115 of the enclosure 110, exhausting waste heat to the external environment. The air conditioning unit 130 could be installed on any available side wall, or alternatively mounted on the roof of the enclosure.

Temperature sensors (not shown) may be located at appropriate places within and around the enclosure 110 to measure the temperature of air within the enclosure. Such sensors may be in the form of, for example, thermocouples or thermistors. To co-ordinate operation of the air inlet fan 228 and the air conditioning unit 130, a control unit or controller 230 may be provided, the controller 230 being connected to both the air inlet fan 228 and air conditioning unit 130, and to the temperature sensors positioned throughout the enclosure 110. The control unit 230 can be configured to operate the air conditioning unit 130 and air inlet fan 228 in order to minimise energy wastage during operation of the cooling system in the enclosure 110. A typical controller will comprise a microprocessor having a number of inputs and outputs, the inputs being connected to one or more temperature sensors located in the enclosure 110, and the outputs configured to control operation of the air conditioner 130 and inlet fan 228, for example through control of one or more electrical relays. Temperature sensors may be advantageously positioned within the internal volume 115 of the enclosure 110, and within the conduit 125, preferably in the air flow upstream from the air bypass 240, so as to monitor the air temperature of the internal volume of the cabinet 121.

Since operation of the air conditioning unit 130, shown in figures 2 and 3, involves consumption of substantially larger amounts of energy compared with operation of the fan 227 alone, the air conditioning unit 130 is preferably configured to operated only when the cooling offered by the configuration shown in figure 2 is insufficient, i.e. when a measured temperature, T_{I}, of the internal volume 115 exceeds a preset maximum. This temperature may be a measurement of the air flowing through the conduit 125, since this is an indication of the temperature of the equipment within the cabinet 121. The preset maximum, Tₘₐₓ, may be set according to a maximum external temperature together with a minimum temperature differential, ΔTₘᵢₙ, offered by operating the enclosure 110 in the first configuration of figure 2, i.e. with fan cooling only. For example, if the enclosure is able to operate with a minimum temperature differential between the internal and external air temperature of 5°C (ΔTₘᵢₙ=5°C), and the maximum preset temperature of air within the internal volume is 35°C (Tₘₐₓ=35°C), an external air temperature of 30°C or more will require active cooling of the enclosure 110 through use of the air conditioning unit 130.

Once the air conditioning unit 130 is in operation, the air temperature within the enclosure 110 can fall rapidly, with the result that cold air could be exhausted through the first outlet 206 before the equipment within the cabinet has had chance to cool down to a desired temperature. Exhausting air from the enclosure 110 that is cooler than the external environment is clearly wasteful, and will result in the air conditioning unit 130 needing to work harder to achieve the cooling effect required. The air inlet fan 228 is therefore disabled when the air conditioner 130 is operational.

With the air conditioning unit 130 in operation, and the and the air inlet fan 228 disabled, as shown in figure 3, the recirculating internal air temperature, T_{I}, is monitored and compared with the external temperature, T_{E}. If T_{I} exceeds T_{E} by a preset amount (which may be zero) while T_{E} is below the maximum allowed internal temperature by more than the minimum temperature differential, ΔTₘᵢₙ, the controller 230 sends a signal to the air conditioning unit 130 to cease operation. The air conditioning unit 130 can thereby be switched off when it is not needed, i.e. when the external air temperature is sufficiently low to allow for cooling by means of forced air flow through the enclosure alone.

Once the air conditioning unit is switched off, the air inlet fan 228 can remain disabled to allow air to carry on recirculating within the enclosure, until the internal recirculating air temperature, T_{I}, rises to level approaching, but below, Tₘₐₓ, i.e. Tₘₐₓ-ΔT, where ΔT is an arbitrary temperature differential chosen according to the cooling capacity of the enclosure in fan-only mode. The controller 230 then sends a signal to enable the air inlet fan 288, returning to the through-flow mode of figure 2.

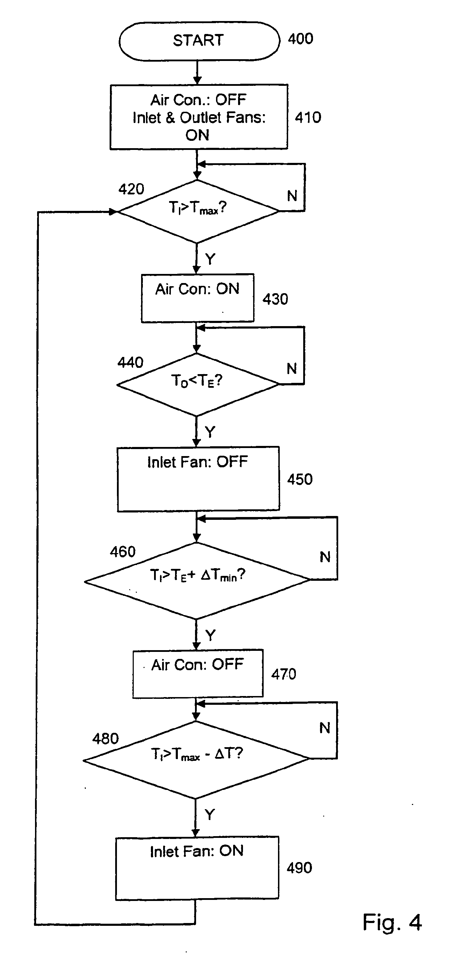

The above sequence of steps is illustrated in flowchart form in figure 4, which represents the logic decisions a suitably programmed controller 230 can make to operate the cooling system of the enclosure 110. The sequence starts (step 400), with the enclosure 110 in the first configuration, i.e. with the air conditioning unit 130 off and both fans 228, 127 enabled (step 410). The controller compares the internal temperature T_{I} with the maximum temperature Tₘₐₓ (step 420). If T_{I}>Tₘₐₓ, the air conditioning unit 130 is switched on (step 730). The controller 230 then compares the outlet temperature To with the external air temperature T_{E} (step 440). If T_{O}<T_{E}, the air inlet fan 228 is disabled (step 450). The controller 230 then compares the internal temperature T_{I} with the external temperature T_{E}, accounting for the minimum temperature differential ΔTₘᵢₙ (step 460). If T_{I}>T_{E}+ ΔTₘᵢₙ and provided T_{E}+ ΔTₘᵢₙ is not equal or greater than Tₘₐₓ, the air conditioning unit 130 is switched off (step 470). The controller 230 then compares the internal temperature T_{I} with the maximum allowable temperature, accounting for a preset differential ΔT (step 480). If T_{I}>Tₘₐₓ - ΔT, the air inlet fan 228 is enabled (step 490). The cooling system is then in the state in which the process began, and the controller returns to monitoring the internal temperature (step 420).

Instead of carrying out some steps of the above process in sequence, some can be carried out together, or without waiting for a further test to be fulfilled. For example, step 480 could be omitted, resulting in the air inlet fan 228 being enabled as soon as the air conditioning unit 130 is switched off. Alternatively or additionally, step 440 could be omitted, resulting in the air inlet fan 228 being disabled as soon as the air conditioning unit is switched on.

To avoid overcooling of equipment within the enclosure when the external temperature is low (for example at night), the air inlet fan 228 may be disabled if the measured air temperature passing through the exhaust 150 falls below a preset level. Heat generated by the equipment within the enclosure can then be used to warm the internal volume of the enclosure, and prevent temperature sensitive equipment (such as batteries) from being overcooled.

In the event of failure of the air conditioning unit 130, e.g. due to an equipment fault or a power cut, the controller 230 may be configured to enable the air inlet fan 228 to avoid excessive overheating. In order to achieve this, the temperature of the air flow through the diverter 210 can be compared by the controller 230 to a further high temperature set point, and the diverter 210 switched once this set point is exceeded. Preferably, in such a situation, the controller 230 is configured to also send an alarm signal (e.g. by radio communication) for informing a remote user of the failure, so that repair of the air conditioning unit 130 can be carried out. The enclosure 110 can thereby be rescued by being kept running with a reduced level of cooling enabled by the fans 228, 127 alone, which can be powered by a battery backup facility in the enclosure 110 if the air conditioning unit 130 fails due to an electrical power cut.

Other embodiments are within the scope of the invention, as defined by the appended claims.

## Claims

1. A temperature-controllable equipment enclosure (110) comprising:
an air inlet (113) having an inlet fan (228) arranged to supply air into the enclosure (110) from an external environment through the air inlet (113) to provide a positive air pressure within the enclosure (110) when enabled;
an air outlet (150);
a conduit (125) extending between the outlet (150) and an equipment cabinet (121) within the internal volume (115) of the enclosure (110); and
an exhaust fan (127) arranged to drive air through the cabinet (121) and conduit (125) towards the outlet (150),
**characterised in that** the conduit (125) comprises a passive air bypass (240) connecting the internal volume (115) of the enclosure (110) with the interior of the conduit (125), such that air driven by the exhaust fan (127) is recirculated within the internal volume (115) of the enclosure (110) when the inlet fan (228) is disabled and is exhausted from the enclosure (110) through the air outlet (150) when the air inlet fan (228) is enabled.

2. The enclosure (110) of claim 1 wherein the air bypass (240) comprises one or more holes in a wall of the conduit (125).

3. The enclosure (110) of claim 1 wherein the air bypass (240) comprises one or more holes in a manifold (126) extending between the conduit (125) and the cabinet (121).

4. The enclosure (110) of any preceding claim comprising an air conditioning unit (130) configured to operate to cool air within the enclosure (110) if an air temperature within the enclosure (110) exceeds a preset maximum temperature.

5. The enclosure (110) of any preceding claim comprising a controller (230) configured to disable the air inlet fan (228) in response to a temperature reading of air passing through the conduit (125) falling below a preset minimum temperature.

6. The enclosure (110) of claim 4 comprising a controller (230) configured to disable the air inlet fan (228) when the air conditioning unit (130) is operational.

7. The enclosure (110) of any preceding claim comprising a valve (220) biased towards a closed position and configured to restrict air flow through the conduit (125) towards the air outlet (150) when the inlet fan (228) is disabled.

8. A method of operating a temperature-controllable equipment enclosure (110) according to claim 1, the method comprising:
operating the inlet fan (228) to drive air into the enclosure (110);
operating the exhaust fan (127) to drive air through the conduit (125) towards the air outlet (150); and **characterised by**
ceasing operation of the inlet fan (228) and continuing operation of the exhaust fan (127) when a measured air temperature within the internal volume (115) of the enclosure (110) falls below a preset minimum temperature, to cause air to recirculate within the internal volume (115) via the air bypass (240).

9. The method of claim 8 wherein the air inlet fan (228) is disabled in response to a temperature reading of air passing through the conduit (125) falling below the preset minimum temperature.

## Patentansprüche

1. Gerätegehäuse(110) mit Temperatursteuerung, umfassend:
einen Lufteinlass (113), der einen Einlassventilator (228) hat, welcher zur Zufuhr von Luft aus der Umgebung durch den Lufteinlass (113) in die Anlage (110) ausgelegt ist, um für einen positiven Luftdruck innerhalb der Anlage (110) zu sorgen, wenn er aktiviert ist;
einen Luftauslass (150);
eine Leitung (125), die sich zwischen dem Auslass (150) und einem Geräteschrank (121) im Innenraum (115) der Anlage (110) erstreckt; und
einen Auslassventilator (127), der zum Bewegen von Luft durch den Schrank (121) und die Leitung (125) hindurch zum Auslass (150) ausgelegt ist,
**dadurch gekennzeichnet, dass** die Leitung (125) einen passiven Luftbypass (240) umfasst, der den Innenraum (115) des Gehäuses (110) mit dem Inneren der Leitung (125) verbindet, so dass Luft, die durch den Auslassventilator (127) bewegt wird, innerhalb des Innenraums (115) der Anlage (110) umgewälzt ist, wenn der Einlassventilator (228) deaktiviert ist, und aus dem Gehäuse (110) durch den Luftauslass (150) abgelassen wird, wenn der Lufteinlassventilator (228) aktiviert ist.

2. Gehäuse (110) nach Anspruch 1, wobei der Luftbypass (240) ein oder mehrere Löcher in einer Wand der Leitung (125) umfasst.

3. Gehäuse (110) nach Anspruch 1, wobei der Luftbypass (240) ein oder mehrere Löcher in einem Verteiler (126) umfasst, der sich zwischen der Leitung (125) und dem Schrank (121) erstreckt.

4. Gehäuse (110) nach einem der vorherigen Ansprüche, das eine Klimatisierungseinheit (130) umfasst, welche zum Kühlen von Luft innerhalb des Gehäuses (110) ausgelegt ist, wenn eine Lufttemperatur innerhalb des Gehäuses (110) eine vorgegebene Maximaltemperatur übersteigt.

5. Gehäuse (110) nach einem der vorherigen Ansprüche, das einen Controller (230) umfasst, welcher zum Deaktivieren des Lufteinlassventilators (228) als Reaktion auf eine Temperaturmessung von Luft ausgelegt ist, die durch die Leitung (125) strömt, wenn sie unter eine vorgegebene Mindesttemperatur fällt.

6. Gehäuse (110) nach Anspruch 4, das einen Controller (230) umfasst, welcher zum Deaktivieren des Lufteinlassventilators (228) ausgelegt ist, wenn die Klimatisierungseinheit (130) in Betrieb ist.

7. Anlage (110) nach einem der vorherigen Ansprüche, die ein Ventil (220) umfasst, welches durch Vorspannung geschlossen und dafür ausgelegt ist, die Luftströmung durch den Kanal (125) zum Luftauslass (150) zu begrenzen, wenn der Einlassventilator (228) deaktiviert ist.

8. Verfahren zum Betreiben eines Gerätegehäuses (110) mit Temperatursteuerung nach Anspruch 1, wobei das Verfahren Folgendes umfasst:
Betreiben des Einlassventilators (228) zum Bewegen von Luft in das Gehäuse (110);
Betreiben des Auslassventilators (127), um Luft durch die Leitung (125) zum Luftauslass (150) zu bewegen; und
**gekennzeichnet durch** Beenden des Betriebs des Einlassventilators (228) und Fortsetzen des Betriebs des Auslassventilators (127), wenn eine gemessene Lufttemperatur innerhalb des Innenraums (115) des Gehäuses (110) unter eine vorgegebene Mindesttemperatur fällt, um so zu bewirken, dass Luft innerhalb des Innenraums (115) über den Luftbypass (240) umgewälzt wird.

9. Verfahren nach Anspruch 8, wobei der Lufteinlassventilator (228) als Reaktion auf eine Temperaturmessung von Luft, die durch die Leitung (125) strömt, welche unter die vorgegebene Mindesttemperatur fällt, deaktiviert ist.

## Revendications

1. Enceinte pour équipements à régulation de température (110), comprenant :
une admission d'air (113) ayant un ventilateur d'admission (228) agencé pour alimenter en air l'enceinte (110) depuis un environnement externe via l'admission d'air (113) afin de fournir une pression d'air positive à l'intérieur de l'enceinte (110) lorsqu'il est activé ;
une sortie d'air (150) ;
un conduit (125) s'étendant entre le refoulement (150) et un coffret d'équipement (121) à l'intérieur du volume interne (115) de l'enceinte (110) ; et
un ventilateur d'échappement (127) agencé pour entraîner l'air à travers le coffret (121) et le conduit (125) vers la sortie (150),
**caractérisée en ce que** le conduit (125) comprend une dérivation d'air passive (240) raccordant le volume interne (115) de l'enceinte (110) avec l'intérieur du conduit (125), de telle sorte que l'air entraîné par le ventilateur d'échappement (127) recircule à l'intérieur du volume interne (115) de l'enceinte (110) lorsque le ventilateur d'admission (228) est désactivé et s'échappe de l'enceinte (110) à travers la sortie d'air (150) lorsque le ventilateur d'admission d'air (228) est activé.

2. Enceinte (110) selon la revendication 1, dans laquelle la dérivation d'air (240) comprend un ou plusieurs trous dans une paroi du conduit (125).

3. Enceinte (110) selon la revendication 1, dans laquelle la dérivation d'air (240) comprend un ou plusieurs trous dans un collecteur (126) s'étendant entre le conduit (125) et le coffret (121).

4. Enceinte (110) selon l'une quelconque des revendications précédentes, comprenant une unité de climatisation (130) configurée pour fonctionner pour refroidir l'air à l'intérieur de l'enceinte (110) si une température de l'air à l'intérieur de l'enceinte (110) dépasse une température maximale préétablie.

5. Enceinte (110) selon l'une quelconque des revendications précédentes comprenant une unité de commande (230) configurée pour désactiver le ventilateur d'admission d'air (228) en réponse à une lecture de température de l'air passant à travers le conduit (125) chutant en dessous d'une température minimale préétablie.

6. Enceinte (110) selon la revendication 4 comprenant une unité de commande (230) configurée pour désactiver le ventilateur d'admission d'air (228) lorsque l'unité de climatisation (130) est opérationnelle.

7. Enceinte (110) selon l'une quelconque des revendications précédentes, comprenant une soupape (220) sollicitée vers une position fermée et configurée pour limiter l'écoulement d'air à travers le conduit (125) vers la sortie d'air (150) lorsque le ventilateur d'admission (228) est désactivé.

8. Procédé d'exploitation d'une enceinte pour équipements à régulation de température (110) selon la revendication 1, le procédé comprenant :
l'exploitation du ventilateur d'admission (228) pour entraîner l'air dans l'enceinte (110) ;
l'exploitation du ventilateur d'échappement (127) pour entraîner l'air à travers le conduit (125) vers la sortie d'air (150) ; et **caractérisé par**
l'arrêt du fonctionnement du ventilateur d'admission (228) et la poursuite du fonctionnement du ventilateur d'échappement (127) lorsqu'une température de l'air mesurée à l'intérieur du volume interne (115) de l'enceinte (110) chute en dessous d'une température minimale préétablie, pour amener l'air à recirculer à l'intérieur du volume interne (115) via la dérivation d'air (240).

9. Procédé selon la revendication 8, dans lequel le ventilateur d'admission d'air (228) est désactivé en réponse à une lecture de température de l'air passant à travers le conduit (125) chutant en dessous de la température minimale préétablie.
